(19) Europäisches Patentamt

European Patent Office

Office européen des brevets

(11) Veröffentlichungsnummer: **0 324 810 B1**

(12) **EUROPÄISCHE PATENTSCHRIFT**

(45) Veröffentlichungstag der Patentschrift: **11.11.92**

(51) Int. Cl.⁵: **C30B 25/14**, C30B 25/08, C23C 16/44

(21) Anmeldenummer: **88905671.9**

(22) Anmeldetag: **30.06.88**

(86) Internationale Anmeldenummer:
**PCT/DE88/00397**

(87) Internationale Veröffentlichungsnummer:
**WO 89/00212 (12.01.89 89/02)**

(54) **OUARZGLASREAKTOR FÜR MOCVD-ANLAGEN.**

(30) Priorität: **30.06.87 DE 3721636**

(43) Veröffentlichungstag der Anmeldung:
**26.07.89 Patentblatt 89/30**

(45) Bekanntmachung des Hinweises auf die Patenterteilung:
**11.11.92 Patentblatt 92/46**

(84) Benannte Vertragsstaaten:
**AT BE CH DE FR GB IT LI LU NL SE**

(56) Entgegenhaltungen:
**DE-A- 3 216 465**

**Journal of Crystal Growth, vol. 77, Nr. 1-3, September 1986, Elsevier Science Publishers B.V. (Amsterdam, NL) G. Landgren et al.: " Novel reactor design for large area uniformity of abrupt heterojunction structures ", pages 67-72, see page 67, last paragraph; page 68, paragraph 1**

**Patent Abstracts of Japan, vol. 6, Nr. 115 (E-115) (993) 26 June 1982 & JP,A,5743411**

**Patent Abstracts of Japan, vol. 10, Nr. 226 (C-364) (2282) 7 August 1986 & JP,A,6158893**

(73) Patentinhaber: **AIXTRON GMBH**
**Jülicher Strasse 336**
**W-5100 Aachen(DE)**

(72) Erfinder: **JÜRGENSEN, Holger**
**Melatenerstr. 56**
**W-5100 Aachen(DE)**
Erfinder: **HEYEN, Meino**
**Schurzelter Mühle 61**
**W-5100 Aachen(DE)**

(74) Vertreter: **Münich, Wilhelm, Dr. et al**
**Kanzlei Münich, Steinmann, Schiller Willibaldstrasse 36/38**
**W-8000 München 21(DE)**

EP 0 324 810 B1

## Beschreibung

### Technisches Gebiet

Die Erfindung bezieht sich auf einen Reaktor für MOCVD-Anlagen, mit einem Reaktionsgefäß, das von dem bzw. den Reaktionsgasen durchströmt wird, und in dem die Substrate derart angeordnet sind, daß eine Hauptoberfläche in etwa parallel zur Strömungsrichtung ist.

### Stand der Technik

Ein Reaktor gemäß dem Oberbegriff des Anspruchs 1 ist aus "Journal of Crystal Growth" 77 (1986), S. 67-72 bekannt. Bei diesem Reaktor besteht das Problem, daß sich eine Diffusionsgrenzschicht zwischen der Reaktionsgas-Strömung und den Substraten ausbildet, deren Anstand von der Substratoberfläche mit wachsendem Anstand vom eintrittsseitigem Ende des Reaktionsgefäßes zunimmt. Hierdurch wird die Homogenität der erzeugten Schichten verschlechtert.

Erfindungsgemäß ist nun erkannt worden, daß das Problem der Diffusionsgrenzschicht, deren Anstand in Strömungsrichtung zunimmt, dadurch gelöst werden kann, daß die Reaktionsgase mit hoher Strömungsgeschwindigkeit an den Substraten vorbeiströmen. Hierdurch erhält man eine Grenzschicht, die nahezu parallel und mit geringem Anstand zur Hauptoberfläche der Substrate verläuft.

Ferner sollte dann mit niedrigen Drücken im Bereich zwischen 10 und 1000 mbar gearbeitet werden, um den Materialeinsatz gering zu halten.

Erfindungsgemäß ist allerdings weiter erkannt worden, daß es in den bekannten REaktoren mit rundem Querschnitt nicht ausreichend ist, die Strömungsgeschwindigkeit zu erhöhen sowie gegebenenfalls der Totaldruck zu erniedrigen, da dann bei den bekannten Reaktoren gemäß dem Oberbegriff des Anspruchs 1 Verwirbelungen etc auftreten, durch die die Bildung homogener Mischkristallschichten verhindert wird.

### Darstellung der Erfindung

Der Erfindung liegt die Aufgabe zugrunde, einen Reaktor für MOCVD-Anlagen, mit einem Reaktionsgefäß, das von dem bzw. den Reaktionsgasen durchströmt wird, und in dem die Substrate derart angeordnet sind, daß eine Hauptoberfläche in etwa parallel zur Strömungsrichtung ist, derart weiterzubilden, daß bei hohen Strömungsgeschwindigkeiten sowie gegebenenfalls niedrigen Drücken homogene Strömungsverhältnisse ohne großen apparativen Aufwand erzielbar sind.

Eine erfindungsgemäße Lösung dieser Aufgabe ist mit ihren Weiterbildungen in den Patentansprüchen gekennzeichnet:

Erfindungsgemäß besteht das Reaktionsgefäß in an sich bekannter Weise aus Quarzglas und weist wenigstens in dem Bereich, in dem die Reaktionsgase strömen, einen rechtekkigen Querschnitt auf. Hierdurch werden gleiche Strömungsverhältnisse über die Querabmessung der Substrate erreicht.

Da rechteckige Rohre aus Quarzglas wenig stabil gegen Druckunterschiede, wie sie beim Evakuieren des Rohrs auftreten, sind, ist ein Schutzrohr vorgesehen, das das Reaktionsgefäß umgibt. Das Schutzrohr weist einen stirnseitigen Reaktionsgaseinlaß, der mit einem Flanschelement verbunden ist, an das ein am Reaktionsgefäß angebrachtes Flanschelement anflanschbar ist. Hierdurch wird erreicht, daß ein glatter Strömungskanal vom Flansch des Schutzrohres zum Innenraum des Reaktionsgefäßes existiert, in dem gegebenenfalls eine Anpassung vom runden Querschnitt des Flansches zum rechteckigen Querschnitt des Reaktionsgefäßes im Bereich der Substrate erfolgen kann, ohne daß Totvolumina auftreten würden, die ein schnelles "Umschalten" verschiedener REaktionsgase verhindern würden.

Zur Vereinfachung der Handhabung sowie der Herstellung und insbesondere auch zur Verringerung der Gefahr von Glasbruch durch Temperaturunterschiede ist das Reaktionsgefäß nur einseitig fest mit dem Schutzrohr verbunden. Um bei einem derartigem Aufbau zu verhindern, daß Reaktionsgase aus dem Reaktionsgefäß austreten und sich auf der (kälteren) Wand des Schutzrohres niederschlagen, ist eine Spülung des Zwischenraumes Reaktionsgefäß/Schutzrohr vorgesehen. Hierzu ist in der Mantelfläche ein Schutzgaseinlaß, der das Spülen des Raumes zwischen Reaktionsgefäß und Schutzrohr erlaubt, und ein Reaktionsgasauslaß vorgesehen. Die Reaktionsgase werden in dem Reaktionsgefäß umgelenkt und treten durch eine mit dem Reaktionsgasauslaß korrespondierende Öffnung im Reaktionsgefäß aus. Einen Austritt der Reaktionsgase in das Schutzrohr verhindert die Diffusionssperre, die an dem dem Gas-eintrittsseitigem Ende entgegengesetztem Ende des Reaktionsgefäßes vorgesehen ist.

Weiterbildungen der Erfindung sind in den Unteransprüchen vorgesehen.

Gemäß Anspruch 2 ist ein Substratträger derart ausgebildet, daß die Substrate in einer Ebene mit der Wand des Flanschelements angeordnet sind. Hierdurch ist sichergestellt, daß keine Verwirbelungen über die Längsabmessungen der Substrate durch Änderungen der Strömungsbedingungen auftreten können.

Im Anspruch 3 ist eine vorteilhafte Weiterbildung gekennzeichnet, bei der sich der Substratträger lediglich über einen Teil der Länge des Reaktionsgefäßes erstreckt, und im Anschluß an den Substratträger ein Ausgleichselement vorgesehen ist, das sich bis zu dem dem eintrittsseitigen Ende des Reaktionsgefäßes entgegengesetztem Ende erstreckt.

In den Ansprüchen 4 bis 6 sind Maßnahmen gekennzeichnet, durch die zum einen die Strömung durch das Innere des Reaktionsgefäßes turbulenzfrei gelenkt, und zum anderen der Austritt von Reaktionsgasen in das Schutzrohr verhindert wird.

Die im Anspruch 7 gekennzeichneten Merkmale erlauben es insbesondere dann, wenn auch das Schutzrohr aus Quarzglas besteht und die (gasdichte) Verbindung zwischen Schutzrohr und Reaktionsgefäß durch Glasschliffe erfolgt, in einfacher Weise sicherzustellen, daß die Schliffe ineinandergepreßt werden, da der durch den Außendruck belastete Stößel das Reaktionsgefäß in einer Richtung beaufschlagt, in der die Schliffe ineinandergepreßt werden.

Der erfindungsgemäße MOCVD-Reaktor kann gemäß Anspruch 9 bevorzugt zur Herstellung von III-V- oder II-VI-Mischkristallen bei hohen Gasgeschwindigkeiten von bis zu 20 m/sec und/oder niedrigen Drücken zwischen 10 und 1000 mbar verwendet werden. Insbesondere is es möglich, ihn für TMGa, TMIn Systeme mit MO-Dotierung und/oder $AsH_3$, $PH_3$-Dotierung zu verwenden. Die erzeugten Schichtsysteme sind äußerst homogen, durch die Vermeidung von Totvolumina erhält man "scharfe" Schichtfolgen.

## Kurze Beschreibung der Zeichnung

Die Erfindung wird nachstehend anhand eines Ausführungsbeispiels unter Bezugnahme auf die Zeichnung näher beschrieben, in der zeigen:

Fig. 1    einen Querschnitt durch das Ausführungsbeispiel, und

Fig. 2    eine perspektivische Ansicht dieses Ausführungsbeispiels.

## Beschreibung eines Ausführungsbeispiels

Der in den Figuren dargestellte erfindungsgemäße MOCVD-Reaktor weist ein eigentliches Reaktionsgefäß 1 auf, das in ein Schutzrohr 2 eingesetzt ist. Hierzu weisen die beiden bei dem gezeigten Ausführungsbeispiel aus Quarzglas bestehenden Rohre Schliffe 3 bzw. 4 auf, die eine gasdichte Verbindung herstellen. Ferner weist das Schutzrohr 2 einen stirnseitigen Flansch 5, der als Reaktionsgaseinlaß von einer nicht näher dargestellten Gas-Versorgungseinheit dient, sowie in der Zylinderfläche des Schutzrohres 2 einen Schutzgaseinlaß 6 und einen Reaktionsgasauslaß 7 auf.

Die dem Flansch 5 gegenüberliegende Stirnfläche des Schutzrohres 2 weist ebenfalls einen Flansch 8 auf, der ein ungehindertes Einsetzen des Reaktionsgefäßes 1 in das Schutzrohr 2 erlaubt und mit einer Flanschplatte 9 verschließbar ist.

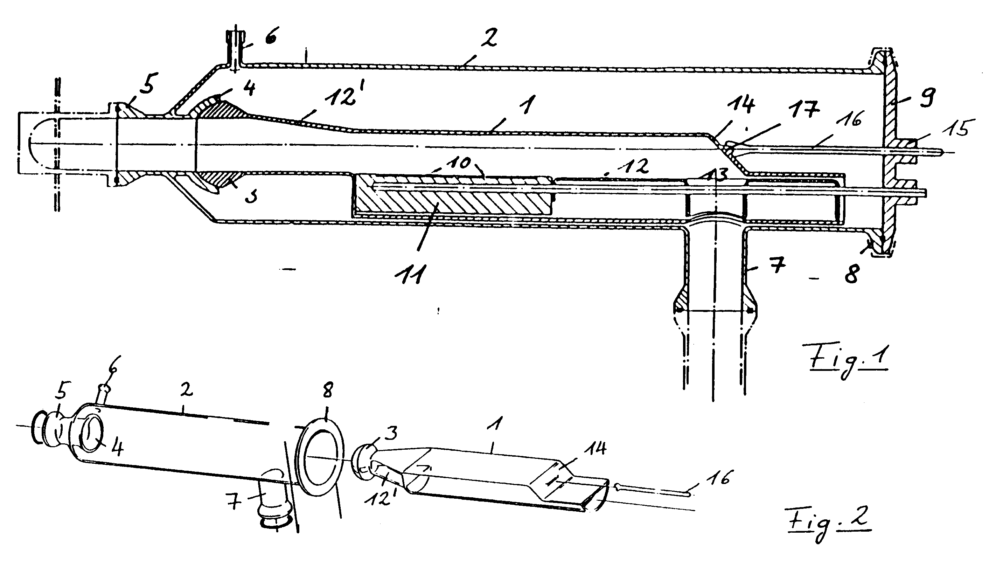

Das Reaktionsgefäß 1 hat in dem Bereich, in dem die Substrate 10 auf einem Substratträger 11 angeordnet sind, im unteren Teil des Querschnitts eine runde und im oberen Teil des Querschnitts eine rechteckige Form (Fig.2). Hierdurch ist sichergestellt, daß die Strömungsverhältnisse über den Substraten 10 in querzur Strömungsrichtung homogen sind. Die Aufweitung der runden Einlaßöffnung des Flansches bzw. Schliffes 3 auf die rechteckige Form des Strömungskanals erfolgt, wie insbesondere aus Fig. 2 ersichtlich ist, kontinuierlich im Abschnitt 12, so daß keine Toträume etc. auftreten können.

Ferner sind erfindungsgemäß lediglich im mittleren Teil des Reaktionsgefäßes 1 Substrate 10 vorgesehen, im hinteren Teil, in dem die Strömung umgelenkt wird, und somit keine konstanten Stömungsverhältnisse mehr gegeben sind, ist ein Ausgleichselement 12 vorgesehen, das "bündig" mit der Substratoberfläche abschließt.

In dem Ausgleichselement 12 befindet sich eine Öffnung 13, die mit dem Reaktionsgasauslaß 7 korrespondiert, so daß die durch den Flansch 5 eintretenden Reaktionsgase wieder entnommen werden können.

Der Querschnitt des Reaktionsgefäßes verringert sich im hinteren Teil auf Abmessungen, die geringfügig größer als die Abmessungen des Substratträgers 11 bzw. des Ausgleichselements 12 sind. Da in den Raum zwischen Schutzrohr 2 und Reaktionsgefäß 1 Schutzgas eingeleitet wird, bildet diese Auslegung des hinteren Teils des Reaktionsgefäßes eine Diffusionssperre, ohne daß ein gasdichte Verbindung am hinteren Ende zwischen Schutzrohr und Reaktionsgefäß bestehen müßte.

Diese Diffusionssperren-Wirkung wird zusätzlich durch die Anordnung einer ca unter 45° geneigten ebenen Fläche 14 oberhalb der Öffnung 13 unterstützt. Die ebene Fläche 14 dient als "Prallplatte" für den schnellen Reaktionsgasstrom.

Hierdurch wird verhindert, daß Reaktionsgas an anderen Stellen als durch die Öffnung 13 bzw. den Flansch 7 austreten kann und sich im Schutzrohr niederschlägt.

Die Flanschplatte 9 weist eine Quetschverschraubung 15 auf, in die ein Strößel 16 eingesetzt ist, der auf einer Nase 17 auf der Fläche 14 aufliegt. Der Stößel 16 wird durch den Druckunterschied zwischen Außendruck und Innendruck in Richtung auf das Reaktionsgefäß belastet und drückt damit die beiden Flansche 3 und 4 zusammen, so daß eine gasdichte Verbindung gewährleistet ist.

Das in den Figuren dargestellte Reaktionsgefäß hat typische Abmessungen von einer Länge von 45 cm und einem Durchmesser von 90 mm, so daß wenigstens zwei 2"-Wafer gleichzeitig bearbeitet werden können.

Vorstehend ist die Erfindung anhand eines Ausführungsbeispiels ohne Beschränkung des allgemeinen Erfindungsgedankens beschrieben worden, innerhalb dessen natürlich die verschiedensten Abwandlungen möglich sind: Beispielsweise sind andere Abmessungen und/oder Materialien möglich.

In jedem Falle erhält man jedoch eine Reaktor, der durch die rechteckige Form des Strömungskanals eine homogene Schichtenherstellung bei hohen Strömungsgeschwindigkeiten von bis zu 20 m/sec und niedrigen Drücken zwischen ca 10 und 1000 mbar ermöglicht. Die Stabilität des Reaktionsgefäßes ist durch das äußere Schutzrohr gewährleistet, dessen Verunreinigung durch die Schutzgasspülung minimiert wird. Der gesamte Aufbau ohne Totvolumina ermöglicht es, schnell die Gas- und/oder Dotierstoffart zu wechseln, so daß "scharfe" Schichtbegrenzungen erhalten werden.

**Patentansprüche**

1.  Reaktor für MOCVD-Anlagen, mit einem Reaktionsgefäß, das von dem bzw. den Reaktionsgasen durchströmt wird, und in dem die Substrate derart angeordnet sind, daß eine Hauptoberfläche in etwa parallel zur Strömungsrichtung ist,
    **gekennzeichnet** durch die Kombination folgender Merkmale:
    - das Reaktionsgefäß (1) besteht in an sich bekannter Weise aus Quarzglas und weist wenigstens in dem Bereich, in dem die Reaktionsgase strömen, einen rechteckigen Querschnitt auf,
    - am Gas-eintrittsseitigen Ende des Reaktionsgefäßes ist ein Flanschelement (3) vorgesehen,
    - ein Schutzrohr (2) umgibt das Reaktionsgefäß,
    - das Schutzrohr weist einen stirnseitigen Reaktionsgaseinlaß (5), der mit einem Flanschelement (4) verbunden ist, an das das Flanschelement (3) des Reaktionsgefäßes anflanschbar ist, und in der Mantelfläche einen Schutzgaseinlaß (6), der das Spülen des Raumes zwischen Reaktionsgefäß und Schutzrohr erlaubt, und einen Reaktionsgasauslaß (7) in der Mantelfläche auf,
    - an dem dem Gas-eintrittsseitigem Ende entgegengesetztem Ende des Reaktionsgefäßes sind eine Diffusionssperre und eine geneigte Fläche (14) vorgesehen, die die Reaktionsgase umlenkt, so daß diese durch den Reaktionsgasauslaß austreten.

2.  Reaktor nach Anspruch 1,
    dadurch **gekennzeichnet,** daß ein Substratträger (11) derart ausgebildet ist, daß die Substrate in einer Ebene mit der Wand des Flanschelements (3) des Reaktionsgefäßes angeordnet sind.

3.  Reaktor nach Anspruch 2,
    dadurch **gekennzeichnet,** daß sich der Substratträger lediglich über einen Teil der Länge des Reaktionsgefäßes erstreckt, und im Anschluß an den Substratträger ein Ausgleichselement (12) vorgesehen ist, das sich bis zu dem dem eintrittsseitigen Ende des Reaktionsgefäßes entgegengesetztem Ende erstreckt.

4.  Reaktor nach Anspruch 3,
    dadurch **gekennzeichnet,** daß in dem Ausgleichselement eine Durchlaßöffnung (13) vorgesehen ist, die den Innenraum des Reaktionsgefäßes mit dem Reaktionsgaßauslaß (7) in der Mantelfläche des Schutzrohres verbindet.

5.  Reaktor nach Anspruch 3 oder 4,
    dadurch **gekennzeichnet,** daß sich das Reaktionsgefäß zur Bildung der Diffusionssperre auf den Querschnitt des Ausgleichselements verengt.

6.  Reaktor nach Anspruch 5,
    dadurch **gekennzeichnet,** daß das Reaktionsgefäß in dem Bereich, in dem die Querschnittverengung erfolgt, einen ebenen Begrenzungs-Wandabschnitt (14) aufweist, der oberhalb der Durchlaßöffnung im Ausgleichselement vorgesehen ist.

7.  Reaktor nach Anspruch 6,
    dadurch **gekennzeichnet,** daß das Schutzrohr an der dem Reaktionsgaseinlaß gegenüberliegenden Stirnfläche einen Flansch (8) aufweist, der mit einer Abdeckplatte (9) verbindbar ist, in die ein Stößel (17) einsetzbar ist, der auf dem ebenen Begrenzungs-Wandabschnitt des Reaktionsgefäßes aufliegt.

8.  Reaktor nach einem der Ansprüche 1 bis 7,
    dadurch **gekennzeichnet,** daß auch das Schutzrohr aus Quarglas besteht, und daß das Reaktionsgefäß mit dem Schutzrohr mittels Schliff-Verbindungen verbunden ist.

9.  Verwendung eines Reaktor nach einem der Ansprüche 1 bis 8 zur Herstellung von III-V- oder II-VI-Mischkristallen bei hohen Gasgeschwindigkeiten von bis zu 20 m/sec und/oder niedrigen Drücken zwischen 10 und 1000 mbar.

## Claims

1. Reactor for MOCVD installations, comprising a reactor vessel for reaction gas(es) flowing therethrough, wherein the substrates are so disposed that one main surface is approximately parallel to the flow direction.
**characterized** by the combination of the following features:
   - the reaction vessel (1) consists, in a manner known per se, of quartz glass and has, at least in the flow region of the reaction gases, a rectangular cross-section,
   - a flange element (3) is provided as the gas inlet side end of the reaction vessel,
   - a protective tube (2) surrounds the reaction vessel,
   - the protective tube has a reaction gas inlet (5) at its face end, which is connected to a flange element (4) adapted for flange-mounting on the flange element (3) provided on the reaction vessel, and comprises a protective gas inlet (6) and a reaction gas outlet (7) in the jacket surface, which protective gas inlet (6) allows for scavenging the space between the reaction vessel and the protective tube,
   - at that end of the reaction vessel, which is opposite to the gas inlet side end, a diffusion barrier and an inclined surface (14) are provided for changing the flow direction of the reaction gases for causing them to discharge through the reaction gas outlet.

2. Reactor according to Claim 1,
**characterized** in that a substrate holder (11) is so configured that the substrates are disposed in the same plane as the wall of the flange element (3) of said reaction vessel.

3. Reactor according to Claim 2,
**characterized** in that said substrate holder extends merely over one part of the length of said reaction vessel, and that said substrate holder is joined by an adjusting element (12) which extends up to the end opposite to the inlet side end of said reaction vessel.

4. Reactor according to Claim 3,
**characterized** in that a passage opening (13) is provided in said adjusting element for communicating the interior space of said reaction vessel with said reaction gas outlet (7) in the jacket surface of said protective tube.

5. Reactor according to Claim 3 or 4,
**characterized** in that said reaction vessel is narrowed to the cross-section of said adjusting element so as to form the diffusion barrier.

6. Reactor according to Claim 5,
**characterized** in that said reaction vessel includes a plane defining wall portion (14) in the region of the reduction of the cross-section, which is provided above the passage opening in said adjusting element.

7. Reactor according to Claim 6,
**characterized** in that said protective tube is provided with a flange (8) at the face surface opposite to said reaction gas inlet, which flange is adapted to be connected to a cover plate (9) into which a pusher element (17) may be inserted which bears against said plane defining wall portion of said reaction vessel.

8. Reactor according to any of Claims 1 to 7,
**characterized** in that said protective tube, too, consists of quartz glass and that said reaction vessel is connected to the protective tube by means of ground joint connectors.

9. Application of a reactor according to any of Claims 1 to 8 for the production of II-V or II-VI mixed crystals at high gas velocities of up to 20 m/sec and/or at low pressures between 10 and 1000 mbar.

## Revendications

1. Réacteur pour des installations MOCVD, qui comprend un récipient réacteur pour du ou des gaz réactionnels le traversants, les substrats y étant disposés d'une façon que une de ses surfaces principales s'étend environ en parallèle au sens d'écoulement.
**caractérisé** par la combinaison des arrangements suivants:
   - le récipient réacteur (1) est fait, d'une façon connue en soi, en verre quartzeux, et présent, au moins dans la zone d'écoulement des gaz réactionnels, une section transversale rectangulaire,
   - un élément de flasque (3) est disposé à l'extrémité côté d'entrée du gaz dudit récipient réacteur,
   - un tube de protection (2) entoure le récipient réacteur,

- le tube de protection est muni d'une entrée de gaz réactionnel (5) à son extrémité frontale, qui est reliée à un élément de flasque (4) adaptée pour être bridé sur ledit élément de flasque (3) pourvu sur ledit récipient réacteur, et qui comprend une entrée de gaz de protection (6) et une sortie de gaz réactionnel outlet (7) dans la surface de l'enveloppement, quelle entrée de gaz de protection (6) permet le vidange de l'espace entre le récipient réacteur et le tube de protection,
- à cette extrémité du récipient réacteur, qui est opposée à l'extrémité côté d'entrée du gaz, on a prévu une barrière de diffusion et une surface inchinée (14) pour changer le sens d'écoulement des gaz réactionnels pour les causer de sortir par la sortie de gaz réactionnel.

2. Réacteur selon la revendication 1,
**caractérisé** en ce qu'un porte-substrat (11) est si configuré que lesdits substrats sont disposés dans le même plan que la paroi de l'élément de flasque (3) dudit récipient réacteur.

3. Réacteur selon la revendication 2,
**caractérisé** en ce que ledit porte-substrat s'étend seulement sur une partie de la longueur dudit récipient réacteur, et en ce que ledit porte-substrat est suivi par un élément compensateur (12) qui s'étend jusqu'à l'extrémité opposée à l'extrémité côté d'entrée dudit récipient réacteur.

4. Réacteur selon la revendication 3,
**caractérisé** en ce qu'une ouverture de passage (13) est formée dans ledit élément compensateur pour la communication de l'intérieur dudit récipient réacteur récipient avec la sorte du gaz réactionnel (7) dans la surface de l'enveloppe dudit tube de protection.

5. Réacteur selon la revendication 3 ou 4,
**caractérisé** en ce que ledit récipient réacteur est réduit à la section transversale dudit élément compensateur pour former la barrière de diffusion.

6. Réacteur selon la Revendication 5,
**caractérisé** en ce que ledit récipient réacteur comprend une portion de paroi de périphérie plaine (14) dans la zone de réduction de coupe transversale, qui se trouve n dessus de l'ouverture de passage dans ledit élément compensateur.

7. Réacteur selon la revendication 6,
**caractérisé** en ce que ledit tube de protection est pourvu d'une flasque (8) à sa surface frontale opposée à l'entrée du gaz réactionnel, laquelle flasque est adaptée à se relier à une plaque de fermeture (9) dans laquelle on peut introduire un poussoir (17) qui porte sur ladite portion de paroi de périphérie plaine dudit récipient réacteur.

8. Réacteur selon une quelconque des revendications 1 à 7,
**caractérisé** en ce que ledit tube de protection est de même fait en verre quartzeux, et en ce que ledit récipient réacteur est relié audit tube de protection au moyen de raccords du type rodé.

9. Application d'un réacteur selon une quelconque des revendications 1 à 8 pour la production de cristaux mixtes du type II-V ou II-VI à des très grandes vitesses de gaz de jusqu'à 20 m/sec et/ou à des basses pressions entre 10 et 1000 mbar.

Fig.1

Fig.2